(19) Europäisches Patentamt
European Patent Office
Office européen des brevets

(11) EP 2 666 628 A1

(12) EUROPEAN PATENT APPLICATION
published in accordance with Art. 153(4) EPC

(43) Date of publication:
**27.11.2013 Bulletin 2013/48**

(21) Application number: **12733865.5**

(22) Date of filing: **11.01.2012**

(51) Int Cl.:
***B32B 15/08*** (2006.01) ***B32B 7/02*** (2006.01)

(86) International application number:
**PCT/JP2012/050372**

(87) International publication number:
**WO 2012/096304 (19.07.2012 Gazette 2012/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.01.2011 JP 2011004505**
**03.08.2011 JP 2011169865**

(71) Applicant: **Toray Industries, Inc.**
**Tokyo 103-8666 (JP)**

(72) Inventors:
- **MAEDA, Yukihiro**
  **Shiga 520-2141 (JP)**
- **ITO, Kiyohiko**
  **Shiga 520-2141 (JP)**

(74) Representative: **Kador & Partner**
**Corneliusstrasse 15**
**80469 München (DE)**

# (54) FAR INFRARED REFLECTING LAMINATE

(57) This far infrared reflecting laminate of the present invention is a far infrared reflecting laminate wherein the following layers [A] to [C] are sequentially arranged in this order: [A] a substrate; [B] a far-infrared reflecting layer having the following structure [B1] or [B2], [B1] a single layer structure of a metal containing 95 to 100% by mass of silver (Ag); or [B2] a multilayer structure composed of a metal layer containing 95 to 100% by mass of silver (Ag) and a layer which contains a metal oxide and/or a metal nitride and which has a refractive index of 1.5 to 3; and [C] a surface hard-coat layer containing a crosslinking resin which has one or more polar groups selected from the group consisting of a phosphoric acid group, a sulfonic acid group, and an amide group and which has a thickness of 0.4 to 2.0 μm. The present invention provides a far infrared reflecting laminate, the surface of which is resistant to scratches.

Fig. 1

[FIG. 1]
1
2
3
4



Printed by Jouve, 75001 PARIS (FR)

## Description

### TECHNICAL FIELD

The present invention relates to a far infrared reflecting laminate.

### BACKGROUND ART

Conventionally, films (see Patent Documents 1 and 2) or glasses provided with an infrared reflecting layer are known as a technique for reducing energy which is required for temperature control or cool keeping by controlling infrared radiation which passes through a window or the like. These infrared reflectors are provided with an infrared reflecting layer having a structure in which a metal thin film layer made of gold, silver, copper, or the like is laminated with a metal oxide layer such as titanium oxide, ITO, or zinc oxide on a substrate which transmits visible light, and can reflect near infrared rays while having transmittability of visible light. Such infrared reflectors are utilized in applications aimed at improving an air conditioning effect by blocking solar energy entered from a window of a building or a vehicle, and aimed at improving a cool keeping effect in a freezer or refrigerating showcase.
As means for physically protecting an infrared reflecting layer, acrylic resins such as methyl polymethacrylate, silicone resins such as a polymer obtained from ethyl silicate, polyester resins, melamine resins, fluorocarbon resins, or the like are described in Patent Document 1 or 2. Polyolefin resins are also known to be used as a protective layer.

### PRIOR ART DOCUMENTS

### PATENT DOCUMENTS

Patent Document 1: Japanese Examined Patent Publication No. Sho 58-010228 (CLAIMS)
Patent Document 2: Japanese Patent Laid-open Publication No. 2001-310407 (Claim 2)

### SUMMARY OF THE INVENTION

### PROBLEMS TO BE SOLVED BY THE INVENTION

When an infrared reflector is used to obtain an effect of heat insulation or heat reduction, the infrared reflector reflects or absorbs near infrared rays of those having high energy in a near infrared region such as sunlight, thereby effectively controlling inflow/outflow of the energy. However, in order to obtain an effect of suppressing outflow of the energy from a room during wintertime or the like, it is important for the infrared reflector to reflect far-infrared rays.
However, as for an infrared reflector formed according to the conventional technique, a hard-coat layer or a glass layer which protects the surface of the infrared reflecting layer inadvertently absorbs far-infrared rays, so that even though the infrared reflector has far infrared reflection performance, it failed to avoid remarkably degrading the far infrared reflection performance. Further, another example is the use of a polyolefin resin such as a biaxial-stretching polypropylene film is used as a protective layer which less absorbs far-infrared rays. However, since the surface of the protective layer is soft, the abrasion resistance is insufficient, so that the surface is easily scratched during operation or in use, thereby failing to exhibit sufficient protection performance as a product to be used for a window or the like.
In order to overcome the above-mentioned problems, an object of the present invention is to provide a far infrared reflecting laminate which has both surface protection performance of resisting scratching of the surface and good far-infrared reflection performance.

### SOLUTIONS TO THE PROBLEMS

The present invention adopts the following means to solve the problems. Specifically, a far infrared reflecting laminate in which the following layers [A] to [C] are sequentially arranged in this order:

[A] a substrate;
[B] a far-infrared reflecting layer having the following structure [B1] or [B2],

[B1] a single layer structure of a metal containing 95 to 100% by mass of silver (Ag); or
[B2] a multilayer structure composed of a metal layer containing 95 to 100% by mass of silver (Ag) and a layer which contains a metal oxide and/or a metal nitride and which has a refractive index of 1.5 to 3; and

[C] a surface hard-coat layer containing a crosslinking resin which has one or more polar groups selected from the group consisting of a phosphoric acid group, a sulfonic acid group, and an amide group and which has a thickness of 0.4 to 2.0 μm.

Another embodiment of the present invention includes a far infrared reflecting laminate in which a substrate, a metal layer, and a surface hard-coat layer are arranged in this order, the metal layer containing 95 to 100% by mass of silver, the surface hard-coat layer having a thickness of 0.4 to 2.0 μm, and in which the far infrared reflecting laminate has a far-infrared reflectance of 60% or more and a surface abrasion resistance of 10 scratches/10 mm or less.

EFFECTS OF THE INVENTION

According to the present invention, a far infrared reflecting laminate, the surface of which is resistant to scratches and which has a good far infrared reflection performance can be provided.

BRIEF DESCRIPTION OF THE DRAWINGS

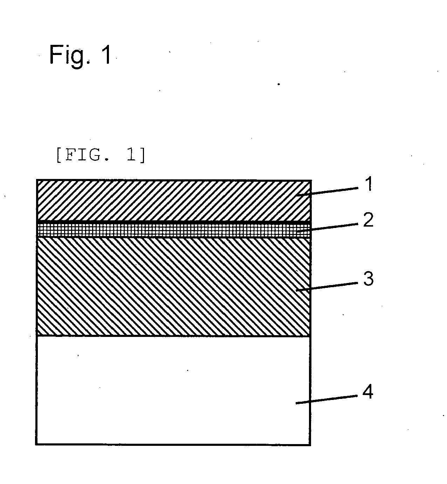

FIG. 1 is a sectional schematic view of the far infrared reflecting laminate in Example 3.

EMBODIMENTS OF THE INVENTION

Each layer structure according to the present invention will be,described below.

[Substrate]

The substrate [A] used in the present invention is selected from resin, metal, metal oxide, and natural materials such as paper or wood, according to the application used for the far infrared reflecting laminate. In the case of a far infrared reflecting laminate applied for applications used for windows to take in natural light or to observe inside, it is preferable that the substrate [A] is a transparent resin or glass which permits transmittance of visible light. In order to facilitate handling, it is more preferable that the substrate [A] is a transparent resin film having flexibility. As a material of the resin film, exemplified are aromatic polyesters represented by polyethylene terephthalate and polyethylene-2,6-naphthalate; aliphatic polyamides represented by nylon 6 and nylon 66; aromatic polyamides; polyolefins represented by polyethylene and polypropylene; and polycarbonates. Among them, aromatic polyesters are preferable in terms of cost, ease of handling, and resistance to the heat received when a laminate is processed. Of these, polyethylene terephthalate or polyethylene-2, 6-naphthalate is preferable, and a polyethylene terephthalate film is particularly preferable. In addition, a biaxial stretching film having enhanced mechanical strength is preferable, and a biaxial-stretching polyethylene terephthalate film is particularly preferable. From the viewpoints of ease of handling and improvement of productivity due to lengthening of a processing unit, the thickness of the film is preferably in the range of 5 to 250 μm, and more preferably 15 to 150 μm.

[Far-Infrared Reflecting Layer]

The far-infrared reflecting layer [B] is a layer having a structure of the following [B1] or [B2] excellent in visible light transmission characteristic and far-infrared reflection characteristic.

[B1] A single layer structure of a metal containing 95 to 100% by mass of silver (Ag)
[B2] A multilayer structure which is composed of a metal layer containing 95 to 100% by mass of silver (Ag) and a layer which contains a metal oxide and/or a metal nitride and which has a refractive index of 1.5 to 3

Generally, metal layers excellent in conductivity have a performance of reflecting far-infrared rays, and it is known that a metal layer is used to increase its conductivity in order to improve reflexibility of far-infrared rays. However, when the metal layer is thickened to improve conductivity, visible light is increasingly absorbed or reflected by the metal layer, so that the performance of transmitting visible light is degraded. Therefore, in order to obtain a high far-infrared reflection performance as well as an excellent photopic transmittance, it is preferred to use a metal layer which is excellent in conductivity or visible light transmittance and which contains 95 to 100% by mass of Ag, as a metal layer commonly contained in the structures of [B1] and [B2].

As a material of the metal layer which contains 95 to 100% by mass of Ag, an alloy of Ag and at least one metal selected from the group consisting of Au, Pt, Pd, Cu, Bi, Ni, Nd, Mg, Zn, Al, Ti, Y, Eu, Pr, Ce, Sm, Ca, Be, Si, Ge, Cr, Co and Ni is preferable. Alloying of Ag with such metal can suppress deterioration of Ag due to reaction with sulfur, oxygen, or the like, and can prevent occurrence of disadvantages such as aggregation during formation of the metal layer. For a good visible light transmission characteristic and a good far-infrared reflection characteristic, the metal layer contains preferably 95 to 100% by mass of Ag, and more preferably 98 to 100% by mass or more of Ag. The metal used as the alloy with Ag can be appropriately selected depending on far-infrared reflection performance, photopic transmittance, chemical resistance, and environmental resistance to be required. It is preferable that the above-mentioned alloy contains a metal selected from 0.2 to 2% by mass of Au, Pd, Cu, Bi, and Nd. For example, Ag alloys, such as an alloy of Ag and 1% by mass of Au; an alloy of Ag, 1% by mass of Pd, and 1% by mass of Cu; an alloy of Ag, 1% by mass of Bi, and 1% by mass of Au; and an alloy of Ag, 0.2% by mass of Nd, and 1% by mass of Au, are preferable.

In the case where the far-infrared reflecting layer [B] has the structure of [B1], the single layer structure means that the far-infrared reflecting layer [B] is made of a single layer of a metal containing 95 to 100% by mass of silver (Ag). Such a single layer structure is advantageous for the stabilization of layer quality or improvement in productivity because the structure is simple. When the far-infrared reflecting layer [B] has the structure of [B1], the [B] layer has a thickness of preferably 5 to 20 nm, and more preferably 10 to 15 nm.

It is also possible to further provide a metal thin layer which is composed of a metal selected from Y, Ti, Zr, Nb, Ta, Cr, Mo, W, Ru, Ir, Pd, Pt, Cu, Au, Al, Ce, Nd, Sm, Tb, and the like, or a mixture thereof so as to cover a surface or both surfaces of the layer of the metal containing 95 to 100% by mass of Ag. In order to protect the layer of the metal containing 95 to 100% by mass of Ag from corrosion, it is preferable that the above-mentioned metal thin layer has a thickness of 0.5 nm or more. Further, in order to obtain good visible light transmission performance, it is preferable that the above-mentioned metal thin layer has a thickness of 10 nm or less. In order to obtain both protection performance and visible light transmission performance, it is even more preferable that the above-mentioned metal thin layer has a thickness of 1 nm or more and 5 nm or less. The above-mentioned metal thin layer is a protective layer that is provided to protect the layer of the metal containing 95 to 100% by weight of Ag from corrosion, and has less influence on the characteristics such as far-infrared reflection performance. Therefore, the metal thin layer should be excluded when the thickness of the [B] layer is considered in regard to characteristics such as far-infrared reflection performance.

In the case of obtaining both a high photopic transmittance and a high far-infrared reflectance, the far-infrared reflecting layer [B], when having the structure of [B1], has a surface resistance of preferably 3 to 30 Ω/□, and more preferably 5 to 10 Ω/□. On the other hand, in the case where visible light transmission performance is unnecessary and far-infrared reflection performance alone is required, it is preferable that the [B] layer has a surface resistance of less than 3 Ω/□ in order to enhance infrared reflection performance. It should be noted, however, that the surface resistance in this context is a value obtained by measuring by a four-terminal four-probe method and a constant current applied method (the same applies hereinafter).

In the case where the far-infrared reflecting layer [B] has the structure of [B2], the multilayer structure means a structure in which at least one metal layer containing 95 to 100% by mass of silver (Ag) and at least one layer (hereinafter referred to as a high refractive index layer in some cases) containing a metal oxide and/or a metal nitride and having a refractive index of 1.5 to 3 are laminated in the far-infrared reflecting layer [B]. It is preferable that the metal layer and the high refractive index layer are combined to suppress interface reflection, so that a good visible light transmission characteristic is obtained. Specifically, the metal layer containing 95 to 100% by mass of Ag has a low refractive index of, for example, 0.3 or less, and the effect of reflection on the interface or the like may deteriorate visible light transmittance. On the contrary, when the metal layer and the high refractive index layer having a refractive index of 1.5 to 3 are combined to form a multilayer structure, the interface reflection of visible light can be reduced. Therefore, it is preferable that the far-infrared reflecting layer [B] is composed of a structure in which a plurality of metal layers and a plurality of high refractive index layers are alternately laminated, in order to suppress the interface reflection, so that a good visible light transmission characteristic is obtained. Such a multilayer structure can control a visible light absorption characteristic to thereby further improve optical characteristics.

The material of the high refractive index layer can be appropriately selected from oxides such as titanium oxide, zirconium oxide, yttrium oxide, niobium oxide, tantalum oxide, zinc oxide, tin-doped indium oxide (ITO), tin oxide, and bismuth oxide; and nitrides such as silicon nitride; and mixtures thereof or those doped or contained with metal such as aluminum and copper, or carbon, and then used for applications.

In accordance with the refractive index and thickness of the metal layer, and the layer structure, the refractive index and thickness of the high refractive index layer can be appropriately selected so as to suppress interface reflection. In the case where the far-infrared reflecting layer [B] has the structure of [B2], a total thickness of the metal layer containing 95 to 100% by mass of Ag in the far-infrared reflecting layer [B] is preferably 5 to 20 nm, and more preferably 10 to 15 nm. As in the case where it has the above-mentioned [B1] structure, in order to protect the metal layer containing 95 to 100% by mass of Ag, the above-described metal thin layer which covers the metal layer may be additionally provided. In this case, however, the thickness of the metal thin layer is considered excluded from the thickness of the metal layer containing 95 to 100% by mass of Ag in the above-mentioned [B] layer.

In the case where the far-infrared reflecting layer [B] has the structure of [B2], in order to suppress the interface reflection between layers to obtain a good photopic transmittance, the thickness per layer of the high refractive index layer is preferably 2 to 200 nm, and more preferably 5 to 100 nm.

In the case where the far-infrared reflecting layer [B] has the structure of [B2], in order to hold both a high photopic transmittance and a high far-infrared reflectance, the total surface resistance of the metal layer containing 95 to 100% by mass of Ag in the far-infrared reflecting layer [B] is preferably 3 to 30 Ω/□, and more preferably 5 to 10 Ω/□. Here, when the far-infrared reflecting layer [B] contains an n layer of the metal layer containing 95 to 100% by mass of Ag, the thickness of each layer is expressed by t1 to tn and the surface resistance of each layer is expressed by Ps1 to Psn, the total surface resistance Pst can be calculated from the following equation:

$$1/Pst = 1/Ps1 + 1/Ps2 + 1/Ps3 + .... 1/Psn$$

[Surface Hard-Coat Layer]

The surface hard-coat layer [C] of the present invention is a layer which contains a crosslinking resin having at least one polar group selected from the group consisting of a phosphoric acid group, a sulfonic acid group, and an amide group and which has a thickness of 0. to 2.0 μm. When the thickness thereof is less than 0.4 μm, the hard-coat performance becomes poor, resulting in degradation of surface protection performance. On the other hand, when it exceeds 2.0 μm, far-infrared rays are excessively absorbed by the hard-coat layer, which remarkably impedes the performance of the far-infrared reflecting layer.

The surface hard-coat layer [C] protects the surface of the far infrared reflecting laminate of the present invention. As shown below, the surface hard-coat layer [C] may have not only a single layer structure but may have a multilayer structure. When it has a multilayer structure, all the layers from the outside of the far-infrared reflecting layer [B] to the outermost surface of the far infrared reflecting laminate are the surface hard-coat layers [C]. The surface hard-coat layer may have any of (i) a single layer structure of a layer containing a crosslinking resin which has the above-mentioned polar group; (ii) a multilayer structure of a layer containing a crosslinking resin which has the above-mentioned polar group and a layer containing the other crosslinking resin (which may or may not have the above-mentioned polar group); and (iii) an inclined structure of a layer containing a crosslinking resin which has the above-mentioned polar group and the other crosslinking resin (which may or may not have the above-mentioned polar group), in which compositions of both the components continuously change in the thickness direction. (ii) When the multilayer structure or (iii) the inclined structure is employed, the crosslinking resin which has the above-mentioned polar group is contained in at least a layer which contacts the far-infrared reflecting layer [B] (in the case of the multilayer structure), or a region which contacts the far-infrared reflecting layer [B] (in the case of the inclined structure).

As a method of introducing at least one polar group selected from the group consisting of a phosphoric acid group, a sulfonic acid group, and an amide group into the crosslinking resin which has the above-mentioned polarity, there may be used a method of mixing an acrylic acid derivative or a methacrylic acid derivative which has a polar group such as phosphoric acid, amide, and sulfonic acid with an acrylic hard-coating agent which forms crosslinking by irradiating with electromagnetic waves such as ultraviolet rays (hereinafter abbreviated as UV in some cases) and then irradiating the mixture with electromagnetic waves such as ultraviolet rays. As the acrylic acid derivative or methacrylic acid derivative which has a polar group such as phosphoric acid, amide, and sulfonic acid, for example, hydrogen phosphate = bis [2-(methacryloyloxy)ethyl] can be preferably used. Among them, a derivative which contains a phosphoric acid group is preferable. It is possible to improve surface abrasion resistance by containing the crosslinking resin which has the above-mentioned polar group in the surface hard-coat layer [C].

In order to improve the surface abrasion resistance, it is preferable that the surface hard-coat layer [C] has a polar group in an appropriate range. An excessively small or large content of the polar group can deteriorate the surface abrasion resistance. When the polar group is a phosphoric acid group, a normalized intensity value calculated by dividing an intensity of a signal which belongs to phosphorus obtained with a sector magnetic field type secondary ion mass spectroscope by an intensity of a signal which belongs to carbon is used as an index of the content of the phosphoric acid group. In the measurement using a sector magnetic field type secondary ion mass spectroscope, intensity profiles (P [31(P)] profile and C [13(C)] profile) of the signals which belong to phosphorus and carbon in the thickness direction can be obtained. Each signal intensity value at a position of interest from such data is acquired, and a normalized intensity value [P/C] at the position is obtained. In the case of (i) the single layer structure, the average of the normalized intensity value [P/C] in the range of ±50 nm of the center portion of the surface hard-coat layer [C] is in the range of preferably 0.01 to 30, and more preferably 0.1 to 10. In the case of (ii) the multilayer structure or (iii) the inclined structure, a region in the range of 0 to 200 nm from an interface of the far-infrared reflecting layer [B] is referred to as a region [C1], and the maximum value $[P/C]_{(C1)}$ of the normalized intensity value [P/C] in the region [C1] is in the range of preferably 0.01 to 30, and more preferably 0.1 to 10.

In the case where the surface hard-coat layer [C] employs (ii) the multilayer structure or (iii) the inclined structure, a region in the range of 0 to 200 nm from an opposite surface (a surface of the far infrared reflecting laminate) of the far-infrared reflecting layer [B] is referred to as a region [C2], and a normalized intensity value [P/C] at a position 100 nm from a surface of the far infrared reflecting laminate is referred to as a normalized intensity value $[P/C]_{(C2)}$ in the region [C2]. At this time, it is preferable that the normalized intensity value $[P/C]_{(C2)}$ in the region [C2] is 10% or less of the normalized intensity value $[P/C]_{(C1)}$ in the region [C1]. That is, it is preferable that the content of the phosphoric acid group in the region [C2] is extremely smaller than the content of the phosphoric acid group in the region [C1]. Further, it is more preferable that the region [C2] does not contain a phosphoric acid group. While the case where the polar group is a phosphoric acid group has been herein described, the same applies to the sulfonic acid group and the amide group. Though not clear, the reason is assumed that although the polar group which exists in the region [C1], which is an interface region with the far-infrared reflecting layer [B], contributes to improvement in affinity between the surface hard-coat layer [C] and the far-infrared reflecting layer [B], the polar groups which exist in the other regions do not contribute to improvement in affinity, and the excessive existence of the polar group may deteriorate physical properties of the surface hard-coat layer [C] itself.

Therefore, when the surface hard-coat layer [C] has (ii) the multilayer structure or (iii) the inclined structure, it is preferable that the above-mentioned polar group is not contained in regions other than the region [C1] or contained in an amount which does not deteriorate the physical properties of the hard-coat layer itself. The thickness of the region which does not contain the above-mentioned polar group constitutes preferably 20% or more, more preferably 50% or more, and even more preferably 80% or more of the thickness of the surface hard-coat layer [C].

The material of the surface hard-coat layer [C] can be appropriately selected depending on surface abrasion resistance, far-infrared reflection performance, visible light transmission performance, or the like to be required. When irradiated with electromagnetic waves such as ultraviolet rays, an acrylic hard-coating agent is quickly cured to form a surface hard-coat layer. Therefore, a photosensitive acrylic hard-coating agent is preferable because curing is easily controlled.

In order to reform shrinkage and surface hardness of the surface hard-coat layer, blending of inorganic particles is preferable. Preferred examples of the inorganic particles include particles of an oxide which contains at least one element of silicon, aluminium, zirconium, titanium, zinc, germanium, indium, tin, antimony, and cerium. For example, one kind of inorganic particles selected from the group consisting of silica, alumina, zirconia, titanium oxide, zinc oxide, germanium oxide, indium oxide, tin oxide, tin-doped indium oxide (ITO), antimony oxide, and cerium oxide can be used, or two or more kinds thereof can be used in combination. The shape of the inorganic particles is a spherical shape, a hollow shape, a porous shape, a rod shape, a plate shape, a fiber shape, and an amorphous shape, and can be appropriately selected according to the required characteristics. Further, when surface treatment in which a functional group is introduced into the surface of the inorganic particle is performed, the crosslinking reaction of a curing resin and an inorganic particle proceeds, so that the hard-coat characteristics can be further improved. As the surface treatment which introduces a functional group, for example, an organic compound containing a polymerizable unsaturated group and an inorganic particle can be combined. The polymerizable unsaturated group is not particularly limited, and examples thereof include an acryloyl group, a methacryloyl group, a vinyl group, a propenyl group, a butadienyl group, a styryl group, an ethynyl group, a cinnamoyl group, a maleate group, and an acrylamide group.

The thickness of the surface hard-coat layer can be appropriately selected from the combination with hard-coat materials depending on surface abrasion resistance, far-infrared reflection performance, and photopic transmission performance to be required. For example, in order not to remarkably degrade the far-infrared reflection performance, the surface hard-coat layer using a photosensitive acrylic hard-coating agent has a thickness of preferably 1.5 μm or less, more preferably 1.2 μm or less, and even more preferably 0.9 μm or less. From the viewpoint of surface abrasion resistance performance, the thickness thereof is preferably 0.4 μm or more, and more preferably 0.5 μm or more.

[Inner Hard-Coat Layer]

In the far infrared reflecting laminate of the present invention, in order to prevent rupture due to stress concentration on the inner portion of each layer or the interface between layers, it is preferable that an inner hard-coat layer [D] which is composed of a crosslinking resin and has a thickness of 0.2 to 10.0 μm is provided between the substrate and the far-infrared reflecting layer.

The inner hard-coat layer [D] can be appropriately selected as long as it contributes to reduction in the stress concentration to the interface or improvement in adhesion of the far-infrared reflecting layer. Specifically, the scope of composition or characteristics can be appropriately selected in the same spirit as the surface hard-coat layer. However, in terms of being positioned on the inner side of the far-infrared reflecting layer, the inner hard-coat layer [D] can more widely employ the scope of composition or characteristics as compared with the surface hard-coat layer. That is, the above-mentioned polar group is not absolutely necessary in its composition, and a composition which allows far-infrared rays to be highly absorbed, may be adopted. The upper limit of the thickness thereof can be up to 10.0 μm. It is also preferable that an inorganic particle is blended in order to reform shrinkage or surface hardness of the hard-coat layer. Again, in this case, materials (properties, shape, and surface functional group) can be selected in the same spirit as the surface hard-coat layer.

The thickness of the inner hard-coat layer can be appropriately selected from the combination with hard-coat materials depending on surface abrasion resistance and photopic transmission performance to be required. For example, in the inner hard-coat layer using a photosensitive acrylic hard-coating agent, the thickness of the hard-coat layer is preferably thicker in order to obtain good surface abrasion resistance. However, a thicker layer is disadvantageous in terms of stress to the substrate interface caused by coating shrinkage during formation of a hard coat, so that the inner hard-coat layer has a thickness of preferably 0.5 to 10 μm, and more preferably 0.5 to 5 μm. The thicknesses of the surface hard-coat layer and the inner hard-coat layer can be obtained from an SEM observation image.

[Far-Infrared Reflectance of Far Infrared Reflecting Laminate]

The far infrared reflecting laminate of the present invention can design a far-infrared reflectance for applications by adjusting characteristics such as a component, quality, thickness, and a resistance value of the substrate, the far-infrared reflecting layer, the surface hard-coat layer, and if necessary, the inner hard-coat layer or the other structure layers. The far infrared reflecting laminate has a far-infrared reflectance of preferably 60% or more, more preferably 70% or more, and even more preferably 80% or more.

The far-infrared reflectance is measured in accordance with JIS R 3106 (1998), and a reflectance to heat radiation of 283K obtained from the spectral reflectance at a wavelength of 5 to 25 μm is determined as a far-infrared reflectance (%).

[Photopic Transmittance of Far Infrared Reflecting Laminate]

The far infrared reflecting laminate of the present invention can design a photopic transmittance for applications by adjusting a component, quality, and thickness of the substrate, the far-infrared reflecting layer, the surface hard-coat layer, and if necessary, the inner hard-coat layer or the other structure layers. The far infrared reflecting laminate has a photopic transmittance of preferably 40% or more, more preferably 50% or more, and even more preferably 60% or more.

The photopic transmittance is measured in accordance with JIS R 3106 (1998), and a transmittance obtained from the spectral transmittance at a wavelength of 380 to 780 nm is determined as a photopic transmittance (%).

For example, when the far-infrared reflecting layer has a structure in which a 9 to 15 nm-thick metal layer containing 95 to 100% by mass of Ag and a 40 to 60 nm-thick tin-doped indium oxide (ITO) layer are laminated, the far-infrared reflectance and the photopic transmittance which are conflicting characteristics can both provide high numerical values, so that such layers are a preferable combination.

[Surface Abrasion Resistance of Far Infrared Reflecting Laminate]

When the surface hard-coat layer [C] contains a crosslinking resin which has the above-mentioned polar group, the far infrared reflecting laminate of the present invention can have a high surface abrasion resistance even though the thickness of the surface hard-coat layer [C] is relatively thin in the range of 0.4 to 2.0 μm.

The surface abrasion resistance can be measured in the following manner: a far infrared reflecting laminate is fixed to a glass plate, and the laminate surface is rubbed 100 reciprocations using a rubbing apparatus (e.g., RT-200 manufactured by Daiei Kagaku Seiki MFG. Co., Ltd.) while a 500 g load is applied to a 30 mm (in width direction) x 10 mm (in rubbing direction) friction block with a steel wool being fixed thereto. Thereafter, the surface is visually observed. The details are described later.

As for the surface abrasion resistance of the far infrared reflecting laminate of the present invention, when a visual scratch at the time of 100 reciprocations of rubbing is evaluated, it is preferable that there is no visual scratch having a width of 2 mm or more and 10 scratches/10 mm or less of visual scratches are observed, and 5 scratches/10 mm or less of visual scratches are more preferable. When there are 11 scratches/10 mm or more of visual scratches at the time of 100 reciprocations of rubbing, the surface abrasion resistance is low, which is not preferable. In addition, when the surface abrasion resistance is remarkably low, visual scratches having a width of 2 mm or more appear at the time of 100 reciprocations of rubbing, which is not preferable.

[Application]

The far infrared reflecting laminate of the present invention takes advantage of excellent characteristics in far-infrared reflection performance and surface abrasion resistance, and can be used in applications such as improvement in an air conditioning effect by blocking thermal energy flown in and out from a window of a building or a vehicle, improvement of maintaining a thermal environment in a case or a house for plant raising, improvement in a cool keeping effect in a freezer or refrigerating showcase, and reduction of thermal radiation flown in and out from a monitor window at the time of high/low temperature work. In addition, the far infrared reflecting laminate of the present invention is used on surfaces of interior materials such as a wall and a ceiling, furniture, home appliances, and the like, thereby allowing it to be utilized for reducing thermal energy which flows out of a space by radiation of far-infrared rays. Since the far infrared reflecting laminate of the present invention has electromagnetic wave shielding performance, it also has an effect as an electromagnetic shielding material. Further, when the far infrared reflecting laminate using a resin film substrate is used for sticking to a glass plate or the like using a pressure-sensitive adhesive, it also has the effect of preventing scattering when the glass plate is broken or of protecting the glass plate to reduce breakage. In order to prevent a resin film substrate from deteriorating due to ultraviolet rays, it is preferable that an ultraviolet absorber is given to a surface of the resin film substrate or an adhesive layer such as an adhesive.

EXAMPLES

Evaluation methods in Examples are stated below.

(Far-Infrared Reflectance)

An evaluation sample piece was prepared by fixing one end portion of a 50 mm-square far infrared reflecting laminate sample to a 50 mm-square glass plate having a thickness of 3 mm so as not to generate wrinkles or slack, using a double-sided tape (PROSELF (registered trademark) No. 539R manufactured by NITOMS Inc.) cut into a size of 7.5 mm in width and 50 mm in length. According to the following apparatus and measurement conditions, light was entered into the evaluation sample piece from a laminate surface side (a surface hard-coat layer side), and a spectral reflectance of the light rays at 5 to 25 μm wavelengths was measured to obtain a reflectance to heat radiation of 283K in accordance with JIS R 3106 (1998). It should be noted that at a position where a proper surface was not obtained because the far infrared reflecting laminate was partially slackened on one side surface of the evaluation sample, a measured value was found to be low, so that when a measurement position was gradually moved in one evaluation sample piece and then measured, the highest value of all the measurements was determined as a far-infrared reflectance (%) of the evaluation sample piece.

- Measuring apparatus: IR Prestige-21 manufactured by Shimadzu Corporation
- Regular reflection measuring unit: SRM-8000A
- Wave number range: 400-2000 $cm^{-1}$
- Measurement mode: % Transmittance
- Apodization coefficient: Happ-Genzel
- Number of integration: 10 times
- Decomposition: 4.0
- Number of n measured values: Used an average value of three of five evaluation samples, except the maximum value and the minimum value of the samples.

(Photopic Transmittance)

An evaluation sample piece was prepared by fixing one end portion of a 50 mm-square far infrared reflecting laminate sample to a 50 mm-square glass plate having a thickness of 3 mm so as not to generate wrinkles or slack, using a double-sided tape (PROSELF (registered trademark) No. 539R manufactured by NITOMS Inc.) cut into a size of 7.5 mm in width and 50 mm in length. According to the following apparatus and measurement conditions, light was entered into a center portion of the evaluation sample piece from a glass side (opposite surface of the laminate surface side (the surface hard-coat layer side), and a spectral transmittance at 380 to 780 nm wavelengths was measured to obtain a photopic transmittance in accordance with JIS R 3106 (1998).

- Measuring apparatus: UV-3150 manufactured by Shimadzu Corporation
- Wavelength Range: 380-780 nm
- Slit Width: (20)
- Scanning Speed: High
- Sampling: 1 nm
- Grating: 720 nm
- Number of n measured values: Used an average value of three of five evaluation samples, except the maximum value and the minimum value of the samples.

(Surface Abrasion Resistance)

An evaluation sample piece for surface abrasion test was prepared by fixing a 50 mm-square far infrared reflecting laminate sample to a 50 mm-square glass plate having a thickness of 3 mm at both end portions of the sample in a direction parallel to a rubbing direction so as not generate wrinkles or slack on the surface of the sample, using a double-sided tape (PROSELF (registered trademark) No. 539R manufactured by NITOMS Inc.) cut into a size of 7.5 mm in width and 50 mm in length. The laminate surface side (hard-coat layer 1 side) was rubbed using a friction block with a steel wool being fixed thereto according to the following apparatus and conditions, and then, a surface of a 20 mm-square portion in the center portion of the sample was visually observed.

- Rubbing apparatus: RT-200 manufactured by Daiei Kagaku Seiki MFG. Co., Ltd.
- Rubbing speed: 10
- Number of rubbings: 100 reciprocations
- Load: 500 g
- Friction block: 30 mm (in width direction) x 10 mm (in rubbing direction)
- Steel wool: BONSTAR (registered trademark) No.0000 manufactured by Nippon Steel Wool Co., Ltd.
- Number of n measured values: Used an average value of three of five evaluation samples, except the maximum value and the minimum value of the samples.

(Surface Resistance)

The surface resistance (Ω/□) of the far-infrared reflecting layer was measured using Loresta (registered trademark) EP MCP-T360 manufactured by Mitsubishi Chemical Analytech Co., Ltd. (a four-terminal four-probe method and a constant current applied method).

(Thicknesses of Surface Hard-Coat Layer and Inner Hard-Coat Layer)

A sample of the far infrared reflecting laminate was prepared by the following method, and SEM observation was carried out to calculate a thickness of the hard-coat layer of the sample.

1. Sample Preparation

(i) Cross-Section Figuring

- Cut with "Rotary Microtome RMS" manufactured by Nippon Microtome Kenkyusho KK.
- Cutting edge: Steel razor blade (feather single edge)
- Cutting angle with steel razor blade: 3 degrees
- Cut amount: 30 μm

(ii) Sputtering Treatment

Sputtering treatment was carried out with an "Ion Coater IB-3 type" manufactured by EIKO Engineering Co., Ltd.

- Sputtering metal: 85% by mass of Pt + 15% by mass of Pd
- Sputtering conditions: 2 mA for 5 minutes
- Sputtered thickness: Approx. 10 nm

2. SEM Observation

A scanning electron microscope "ABT-32" manufactured by TOPCON CORPORATION was used.

(i) Observation conditions used

- Acceleration voltage: 15 kV
- Spot size level: 6
- Working distance: 20 mm
- Observation angle: 0 degree (with respect to a 90 degree cross-section)
- Observation magnification: 20000 times

(ii) Calculation of thickness

- Calculated from the thickness and the observation magnification which were measured on the SEM image.
- Error correction was carried out using the results obtained by measuring a grating space of 500 x 500 mμ (manufactured by Oken) as standard data in calculation.

(Analysis of Optical Constants (Refractive Index and Extinction Coefficient, Thickness) of Far-Infrared Reflecting Layer)

1. Measurement Method

According to the following apparatus and measurement conditions, change of the state of polarization of the reflected light from the measuring sample was measured, and an optical constant was obtained by a calculation. In the calculation, a spectrum of Δ (phase difference) and φ (amplitude reflectance) measured from the sample was compared with a value (Δ, φ) calculated from the computational model, and a dielectric function was changed so that the value might approach the measured value (Δ, φ) for fitting. The result of the fitting shown here is the result of a best fit (converged by the minimum mean square error) of the measured value and the theoretical value.

2. Apparatus

- High-speed spectroscopic ellipsometer
- M-2000 (manufactured by J. A. Woollam Co., Inc.)
- Rotation compensator type (RCE: Rotating Compensator Ellipsometer)
- 300 mm R-Theta stage

3. Measurement Conditions

- Angle of incidence: 65 degrees, 70 degrees, and 75 degrees
- Measured wavelength: 195 nm - 1680 nm
- Analysis software: WVASE32
- Beam diameter: Order of 1 x 2 mm
- Number of n measured values: 1

(Analysis of Polar Group Component of the Surface Hard-Coat Layer)

1. Measurement Method

According to the following apparatus and measurement conditions, the surface hard-coat layer of the far infrared reflecting laminate sample was measured to acquire a P [31 (P)] profile and a C [13 (C)] profile in its thickness direction, and at each point in the thickness direction, an intensity value of 31(P) was divided by an intensity value of 13 (C) to obtain a normalized intensity [P/C].

In the case of (i) the single layer structure, an average of the normalized intensity values [P/C] in the range of ±50 nm of the center portion of the hard-coat layer [C] was calculated.

In the case of (ii) the multilayer structure or (iii) the inclined structure, [P/C] (C1) and [P/C] (C2) were obtained as follows.

[P/C] (C1): The maximum value of the normalized intensity value [P/C] in a 0 to 200-nm region from the interface of the far-infrared reflecting layer [B] was referred to as [P/C] (C1).

[P/C] $_{(C2)}$: The normalized intensity value [P/C] at a position 100 nm from an opposite surface (a surface of the far infrared reflecting laminate) of the far-infrared reflecting layer [B] was referred to as [P/C] $_{(C2)}$.

2. Apparatus

Sector Magnetic Field Type Secondary Ion Mass Spectroscope

3. Measurement Conditions

- Cs+ ion which was accelerated at an acceleration voltage of 14.5 kV was used for primary ion.
- At the time of analysis, E-gun was used for charge compensation of the sample, and the offset potential of a sample stand was set to 0 V.
- EM (Electron Multiplier) was used for detection of a secondary ion, and m/z = 31 (P) and 13 (C) were detected with a negative ion.
- Mass resolution requires 2000 or more (31 (SiH) and 31 (P), and 13(CH) and 13(C) are fully separable).
- The integration time of C is the same as that of P.
- Number of n measured values: 1

(Evaluation Criteria of Sample)

The far-infrared reflectance, surface abrasion resistance, and photopic transmittance of the samples obtained in Examples and Comparative Examples were measured as described above. Then, their performance was determined in accordance with the following evaluation criteria.

- Far-infrared reflectance

A: 80% or more
B: 60% or more and less than 80%
C: Less than 60%

- Surface abrasion resistance

A: At the time of 100 reciprocations of rubbing, there was no visual scratch having a width of 2 mm or more, and 0 to 5 scratches /10 mm of visual scratches were observed.
B: At the time of 100 reciprocations of rubbing, there was no visual scratch having a width of 2 mm or more, and 6 to 10 scratches /10 mm of visual scratches were observed.
C: At the time of 100 reciprocations of rubbing, there was a visual scratch having a width of 2 mm or more, or 11 scratches/10 mm or more of visual scratches were observed.

- Photopic transmittance

A: 60% or more
B: 40% or more and less than 60%
C: Less than 40%

- Overall evaluation 1

The evaluations of the far-infrared reflectance and the surface abrasion resistance were made according to the following criteria.

A: All the evaluations resulted in A.
B: One of the evaluations resulted in B, and all the others resulted in A.
C: At least two evaluations resulted in B, or any of the evaluations resulted in C.

- Overall evaluation 2

The overall evaluation 1 and the evaluation of the photopic transmittance were made according to the following criteria, and A to C were considered as pass.

A: All the evaluations resulted in A.
B: One of the evaluations resulted in B, and all the others resulted in A.
C: The overall evaluation 1 resulted in B or higher, and at least two evaluations resulted in B, or any of the evaluations resulted in C.
D: The overall evaluation 1 resulted in C, and the photopic transmittance was evaluated as A.
E: The overall evaluation 1 resulted in C, and the photopic transmittance was evaluated as B or lower.

[Example 1]

A PET film (Tuftop (registered trademark) C0T0 (100 μm in thickness) manufactured by Toray Advanced Film Co., Ltd.) which preliminarily has an acrylic hard-coat (coating thickness of 3. 3 μm) was used as an inner hard-coat layer on a substrate.

On the inner hard-coat layer of the film, sputtering processing was carried out at ultimate pressure: 8E-3 Pa, an Ag alloy target (56 mm x 106 mm x 1 plate: Ag and 1% by mass of Au); transfer speed: 0.3 m/min; sputtering gas: Ar; sputtering pressure: 0.5 Pa; and input power: direct current (hereinafter abbreviated as DC in some cases) 105 W, so that a far-infrared reflecting layer having a single layer structure of a metal containing 95 to 100% by mass of Ag was formed.

Subsequently, a surface hard-coat layer composed of a crosslinking resin containing a phosphoric acid group was formed in the following manner. A methacrylic acid derivative (LIGHT ESTER P-2M manufactured by Kyoeisha Chemical Co., Ltd.) containing a phosphoric acid group was mixed with an acrylic hard-coating agent (OPSTAR (registered trademark) Z7535 manufactured by JSR Corporation) which forms crosslinking by irradiating with ultraviolet rays, so as to have 2% by mass in solid content, and the mixture was diluted to a solid concentration of 7.5% by mass, using methyl ethyl ketone as a dilution solvent, so that a coating liquid was obtained. The obtained coating liquid was applied onto the above-mentioned far-infrared reflecting layer using a bar coater (No.10), and then dried at 80°C for 3 minutes. Thereafter, the dried layer was irradiated with UV (use of a mercury lamp, 1200 mJ/cm$^2$), and the coating film was crosslinked to thereby form a surface hard-coat layer.

In the step in which the far-infrared reflecting layer was formed, the surface resistance of the far-infrared reflecting layer was measured to be 1 Ω/□. The thickness of the surface hard-coat layer was 0.8 μm. With a far-infrared reflectance of 93%, a surface abrasion resistance of 3 scratches/10 mm, and a photopic transmittance of 1%, the overall evaluations 1 and 2 resulted in A and C, respectively.

[Example 2]

A sample was obtained in the same manner as in Example 1 except that the transfer speed at the time of forming the far-infrared reflecting layer having a single layer structure of a metal containing 95 to 100% by mass of Ag was set to 0.8 m/min. The results are shown in Tables 1 and 3.

In the step in which the far-infrared reflecting layer was formed, the surface resistance of the far-infrared reflecting layer was measured to be 7 Ω/□. Further, the layer thickness was analyzed using the high-speed spectroscopic ellipsometer in this step, the thickness of the inner hard-coat layer laminated on the Tuftop (registered trademark) C0T0 manufactured by Toray Advanced Film Co., Ltd. was 3.3 μm, and the thickness of the far-infrared reflecting layer was 12.1 nm. The thickness of the surface hard-coat layer was 0.8 μm. With a far-infrared reflectance of 88%, a surface abrasion resistance of 3 scratches/10 mm, and a photopic transmittance of 54%, the overall evaluations 1 and 2 resulted in A and B, respectively.

[Example 3]

A sample was obtained in the same manner as in Example 1 except that as the far-infrared reflecting layer, a far-infrared reflecting layer having a multilayer structure which is composed of a metal layer containing 95 to 100% by mass of Ag, and a high refractive index layer containing a metal oxide and having a refractive index of 1.5 to 3 was formed as follows.

(Method of Forming a Far-Infrared Reflecting Layer)

A metal layer was formed by sputtering processing at ultimate pressure: 2E-3 Pa, an Ag alloy target (76 mm x 330 mm x 2 plates: Ag, 0.2% by mass of Nd, and 1% by mass of Au) ; transfer speed: 3.5 m/min; sputtering gas: Ar; sputtering pressure: 9.5 E-2 Pa; and input power: 1.0 kw of LF power supply (40 kHz). Thereafter, an ITO layer was formed by sputtering processing at a ultimate pressure: 2E-3 Pa or less; ITO target (127 mm x 386 mm x 1 plate: 90% by mass of $In_2O_3$ and 10% by mass of $SnO_2$); transfer speed: 0.9 m/min; sputtering gas: Ar and 3% by volume of $O_2$; sputtering pressure: 9.5E-2 Pa; and input power: 2.5 kw of DC pulse (50 kHz). The results are shown in Tables 1 and 3.

After the ITO layer was formed, the surface resistance was measured to be 9 Ω/□. When points of the P profile are divided by points of the C profile of the surface hard-coat layer observed with a sector magnetic field type secondary ion mass spectroscope to obtain normalized intensities, an average value P/C of the normalized intensities in the range of 400 nm ± 50 nm depth from the surface of the surface hard-coat layer was 1.3. With a far-infrared reflectance of 86%, a surface abrasion resistance of 2 scratches/10 mm, and a photopic transmittance of 67%, the overall evaluations 1 and 2 resulted in A and A, respectively.

[Example 4]

A sample was obtained in the same manner as in Example 3 except that in the step of forming the surface hard-coat layer, a methacrylic acid derivative (LIGHT ESTER P-2M manufactured by Kyoeisha Chemical Co., Ltd.) containing a phosphoric acid group was mixed so as to have 5% by mass in solid content. The results are shown in Tables 1 and 3. With a far-infrared reflectance was 88%, a surface abrasion resistance of 5 scratches/10 mm, and a photopic transmittance of 66%, the overall evaluations 1 and 2 resulted in A and A, respectively.

[Example 5]

A sample was obtained in the same manner as in Example 3 except that in the step of forming the surface hard-coat layer, a methacrylic acid derivative (LIGHT ESTER P-2M manufactured by Kyoeisha Chemical Co., Ltd.) containing a phosphoric acid group was mixed so as to have 10% by mass in solid content. The results are shown in Tables 1 and 3.

When points of the P profile were divided by points of the C profile of the surface hard-coat layer observed with a sector magnetic field type secondary ion mass spectroscope to obtain normalized intensities, an average value P/C of the normalized intensities in the range of 400 nm ± 50 nm depth from the surface of the surface hard-coat layer was 6.2. With a far-infrared reflectance was 86%, a surface abrasion resistance of 7 scratches/10 mm, and a photopic transmittance of 67%, the overall evaluations 1 and 2 resulted in B and B, respectively.

[Example 6]

In the step of forming the surface hard-coat layer, a methacrylic acid derivative (LIGHT ESTER P-2M manufactured by Kyoeisha Chemical Co., Ltd.) containing a phosphoric acid group was mixed so as to have 2% by mass in solid content, and the mixture was diluted to a solid concentration of 0.75% by mass, using methyl ethyl ketone as a dilution solvent, so that a coating liquid was obtained. The obtained coating liquid was applied onto the far-infrared reflecting layer using a bar coater (No.10), and then dried at 80°C for 3 minutes. Next, without adding the methacrylic acid derivative (LIGHT ESTER P-2M manufactured by Kyoeisha Chemical Co., Ltd.) containing a phosphoric acid group, an acrylic hard-coating agent (OPSTAR (registered trademark) Z7535 manufactured by JSR Corporation) was diluted to a solid concentration of 6.75% by mass, using methyl ethyl ketone as a dilution solvent, so that a coating liquid was obtained. The obtained coating liquid was applied onto the above-mentioned far-infrared reflecting layer using a bar coater (No.10), and then dried at 80°C for 3 minutes. Subsequently, the dried layer was irradiated with UV (use of a mercury lamp, 1200 mJ/$cm^2$), and the coating film was crosslinked to thereby form a surface hard-coat layer having a lamination. A sample was obtained in the same manner as in Example 3 except that the surface hard-coat layer was formed as described above. The results are shown in Tables 1 and 3. With a far-infrared reflectance of 85%, a surface abrasion resistance of 2 scratches/10 mm, and a photopic transmittance of 67%, the overall evaluations 1 and 2 resulted in A and A, respectively.

[Example 7]

A sample was obtained in the same manner as in Example 6 except that in the step of forming the surface hard-coat layer, the methacrylic acid derivative (LIGHT ESTER P-2M manufactured by Kyoeisha Chemical Co., Ltd.) containing a phosphoric acid group was mixed so as to have not 2% by mass but 10% by mass in solid content. The results are shown in Tables 1 and 3. With a far-infrared reflectance of 85%, a surface abrasion resistance of 1 scratch/10 mm, and a photopic transmittance of 68%, the overall evaluations 1 and 2 resulted in A and A, respectively.

[Example 8]

A sample was obtained in the same manner as in Example 6 except that in the step of forming the surface hard-coat layer, the methacrylic acid derivative (LIGHT ESTER P-2M manufactured by Kyoeisha Chemical Co., Ltd.) containing a phosphoric acid group was mixed so as to have not 2% by mass but 20% by mass in solid content. The results are shown in Tables 1 and 3. With a far-infrared reflectance of 85%, a surface abrasion resistance of 4 scratches/10 mm, and a photopic transmittance of 68%, the overall evaluations 1 and 2 resulted in A and A, respectively.

[Example 9]

A sample was obtained in the same manner as in Example 1 except that as the far-infrared reflecting layer, a far-infrared reflecting layer having a multilayer structure which is composed of a metal layer containing 95 to 100% by mass of Ag, and a high refractive index layer containing a metal oxide and having a refractive index of 1.5 to 3 was formed as follows.

(Method of Forming a Far-Infrared Reflecting Layer)

First Layer: A $TiO_2$ layer was formed by sputtering processing at ultimate pressure: 2E-3 Pa or less, a Ti target (127 mm x 386 mm x 1 plate); transfer speed: 0.2 m/min; sputtering gas: Ar-35% by volume of $O_2$; sputtering pressure: 0.3 Pa; and input power: 9.5 kw of DC pulse (50 kHz).
Second Layer: A metal layer was formed by sputtering processing at ultimate pressure: 2E-3 Pa or less, an Ag alloy target (76 mm x 330 mm x 2 plates: Ag, 0.2% by mass of Nd, and 1% by mass of Au) ; transfer speed: 3.5 m/min; sputtering gas: Ar; sputtering pressure: 9.5E-2 Pa; and input power: 1.0 kw of LF power supply (40 kHz).
Third Layer: A Ti layer was formed by sputtering processing at ultimate pressure: 2E-3 Pa or less, a Ti target (127 mm x 386 mm x 1 plate; transfer speed: 5.0 m/min; sputtering gas: Ar; sputtering pressure: 0.2 Pa; and input power: 4.3 kw of DC pulse (50 kHz).
Fourth Layer: A $TiO_2$ layer was formed by sputtering processing at ultimate pressure: 2E-3 Pa or less, a Ti target (127 mm x 386 mm x 1 plate; transfer speed: 0.2 m/min; sputtering gas: Ar-35% by volume of $O_2$; sputtering pressure: 0.3 Pa; and input power: 9.5 kw of DC pulse (50 kHz).

The results are shown in Tables 2 and 3. After the $TiO_2$ layer was subjected to sputtering processing, the surface resistance was measured to be 6 Ω/□. With a far-infrared reflectance of 86%, a surface abrasion resistance of 4 scratches/10 mm, and a photopic transmittance of 52%, the overall evaluations 1 and 2 resulted in A and B, respectively.

[Example 10]

A sample was obtained in the same manner as in Example 1 except that as the far-infrared reflecting layer, a far-infrared reflecting layer having a multilayer structure which is composed of a metal layer containing 95 to 100% by mass of Ag, and a high refractive index layer containing a metal oxide and having a refractive index of 1.5 to 3 was formed as follows.

(Method of Forming a Far-Infrared Reflecting Layer)

First Layer: A $TiO_2$ layer was formed by sputtering processing at ultimate pressure: 2E-3 Pa or less, a Ti target (127 mm x 386 mm x 1 plate) ; transfer speed: 0. 2 m/min; sputtering gas: Ar-35% by volume of $O_2$; sputtering pressure: 0.3 Pa; and input power: 9.5 kw of DC pulse (50 kHz).
Second Layer: A metal layer was formed by sputtering processing at ultimate pressure: 2E-3 Pa or less, an Ag alloy target (76 mm x 330 mm x 2 plates: Ag, 0.2% by mass of Nd, and 1% by mass of Au); transfer speed: 3.5 m/min; sputtering gas: Ar; sputtering pressure: 9.5E-2 Pa; and input power: 1.0 kw of LF power supply (40 kHz).

Third Layer: A Ti layer was formed by sputtering processing at ultimate pressure: 2E-3 Pa or less, a Ti target (127 mm x 386 mm x 1 plate; transfer speed: 5.0 m/min; sputtering gas: Ar; sputtering pressure: 0.2 Pa; and input power: 1.7 kw of DC pulse (50 kHz).
Fourth Layer: A $TiO_2$ layer was formed by sputtering processing at ultimate pressure: 2E-3 Pa or less, a Ti target (127 mm x 386 mm x 1 plate; transfer speed: 0.2 m/min; sputtering gas: Ar-35% by volume of $O_2$; sputtering pressure: 0.3 Pa; and input power: 9.5 kw of DC pulse (50 kHz).

The results are shown in Tables 2 and 3. After the $TiO_2$ layer was subjected to sputtering processing, the surface resistance was measured to be 7 Ω/□. With a far-infrared reflectance of 85%, a surface abrasion resistance of 3 scratches/10 mm, and a photopic transmittance of 72%, the overall evaluations 1 and 2 resulted in A and A, respectively.

[Example 11]

A sample was obtained in the same manner as in Example 1 except that as the far-infrared reflecting layer, a far-infrared reflecting layer having a multilayer structure which is composed of a metal layer containing 95 to 100% by mass of Ag, and a high refractive index layer containing a metal oxide and having a refractive index of 1.5 to 3 was formed as follows.

(Method of Forming a Far-Infrared Reflecting Layer)

First Layer: A $Nb_2O_5$ layer was formed by sputtering processing at ultimate pressure: 2E-3 Pa or less, an Nb target (127 mm x 386 mm x 1 plate) ; transfer speed: 0.3 m/min; sputtering gas: Ar-30% by volume of $O_2$; sputtering pressure: 0.3 Pa; and input power: 5 kw of DC pulse (50 kHz).
Second Layer: A metal layer was formed by sputtering processing at ultimate pressure: 2E-3 Pa or less, an Ag alloy target (76 mm x 330 mm x 2 plates: Ag, 0.2% by mass of Nd, and 1% by mass of Au); transfer speed: 3.5 m/min; sputtering gas: Ar; sputtering pressure: 9.5E-2 Pa; and input power: 1.0 kw of LF power supply (40 kHz).
Third Layer: An Nb layer was formed by sputtering processing at ultimate pressure: 2E-3 Pa or less, an Nb target (127 mm x 386 mm x 1 plate; transfer speed: 5.0 m/min; sputtering gas: Ar; sputtering pressure: 0.1 Pa; and input power: 2.3 kw of DC pulse (50 kHz).
Fourth Layer: An $Nb_2O_5$ layer was formed by sputtering processing at ultimate pressure: 2E-3 Pa or less, an Nb target (127 mm x 386 mm x 1 plate; transfer speed: 0.3 m/min; sputtering gas: Ar-30% by volume of $O_2$; sputtering pressure: 0.3 Pa; and input power: 5 kw of DC pulse (50 kHz).

The results are shown in Tables 2 and 3. After the $Nb_2O_5$ layer was subjected to sputtering processing, the surface resistance was measured to be 7 Ω/□. With a far-infrared reflectance of 86%, a surface abrasion resistance of 3 scratches/10 mm, and a photopic transmittance of 53%, the overall evaluations 1 and 2 resulted in A and B, respectively.

[Example 12]

A sample was obtained in the same manner as in Example 1 except that as the far-infrared reflecting layer, a far-infrared reflecting layer having a multilayer structure which is composed of a metal layer containing 95 to 100% by mass of Ag, and a high refractive index layer containing a metal oxide and having a refractive index of 1. 5 to 3 was formed as follows.

(Method of Forming a Far-Infrared Reflecting Layer)

First Layer: A $Nb_2O_5$ layer was formed by sputtering processing at ultimate pressure: 2E-3 Pa or less, an Nb target (127 mm x 386 mm x 1 plate) ; transfer speed: 0.3 m/min; sputtering gas: Ar-30% by volume of $O_2$; sputtering pressure: 0.3 Pa; and input power: 5 kw of DC pulse (50 kHz).
Second Layer: A metal layer was formed by sputtering processing at ultimate pressure: 2E-3 Pa or less, an Ag alloy target (76 mm x 330 mm x 2 plates: Ag, 0.2% by mass of Nd, and 1% by mass of Au); transfer speed: 3.5 m/min; sputtering gas: Ar; sputtering pressure: 9.5E-2 Pa; and input power: 1.0 kw of LF power supply (40 kHz).
Third Layer: An Nb layer was formed by sputtering processing at ultimate pressure: 2E-3 Pa or less, an Nb target (127 mm x 386 mm x 1 plate; transfer speed: 5.0 m/min; sputtering gas: Ar; sputtering pressure: 0.1 Pa; and input power: 0.9 kw of DC pulse (50 kHz).

Fourth Layer: An $Nb_2O_5$ layer was formed by sputtering processing at ultimate pressure: 2E-3 Pa or less, an Nb target (127 mm x 386 mm x 1 plate; transfer speed: 0.3 m/min; sputtering gas: Ar-30% by volume of $O_2$; sputtering pressure: 0.3 Pa; and input power: 5 kw of DC pulse (50 kHz).

The results are shown in Tables 2 and 3. After the $Nb_2O_5$ layer was subjected to sputtering processing, the surface resistance was measured to be 13 Ω/□. With a far-infrared reflectance of 80%, a surface abrasion resistance of 5 scratches/10 mm, and a photopic transmittance of 70%, the overall evaluations 1 and 2 resulted in A and A, respectively.

[Comparative Example 1]

REFTEL (registered trademark) ZC05G (a substrate (a PET film) /a far-infrared reflecting layer composed of a metal layer and a dielectric layer (titanium oxide)/an OPP film) manufactured by Teijin DuPont Films Japan Limited, which has a polyolefin resin on its surface, was used as a sample in Comparative Example 1. The results are shown in Tables 2 and 3. With a far-infrared reflectance of 81%, a surface abrasion resistance of 11 scratches/10 mm or more of countless scratches observed, and a photopic transmittance of 66%, the overall evaluations 1 and 2 resulted in C and D, respectively.

[Comparative Example 2]

A sample was obtained in the same manner as in Example 1 except that in the step of forming the surface hard-coat layer, the methacrylic acid derivative (LIGHT ESTER P-2M manufactured by Kyoeisha Chemical Co., Ltd.) containing a phosphoric acid group was not added. The results are shown in Tables 2 and 3.

The thickness of the surface hard-coat layer in Comparative Example 2 was 0.8 μm. With a far-infrared reflectance of 87%, a surface abrasion resistance of 2 mm-wide or more scratches observed, and a photopic transmittance of 53%, the overall evaluations 1 and 2 resulted in C and E, respectively.

[Comparative Example 3]

A sample was obtained in the same manner as in Example 1 except that in the step of forming the surface hard-coat layer, an acrylic hard-coating agent (OPSTAR Z7535 manufactured by JSR Corporation) was diluted to a solid concentration of 20% by mass, using methyl ethyl ketone as a dilution solvent, so that a coating liquid was obtained, and the obtained coating liquid was applied using a bar coater (No.12). The results are shown in Tables 2 and 3.

The thickness of the surface hard-coat layer in Comparative Example 3 was 3 μm. With a far-infrared reflectance of 54%, a surface abrasion resistance of 0 scratch/10 mm, and a photopic transmittance of 54%, the overall evaluations 1 and 2 resulted in C and E, respectively.

[Comparative Example 4]

A sample was obtained in the same manner as in Example 3 except that in the step of forming the surface hard-coat layer, the methacrylic acid derivative (LIGHT ESTER P-2M manufactured by Kyoeisha Chemical Co., Ltd.) containing a phosphoric acid group was not added. The results are shown in Tables 2 and 3.

When points of the P profile were divided by points of the C profile of the surface hard-coat layer observed with a sector magnetic field type secondary ion mass spectroscope to obtain normalized intensities, an average value P/C of the normalized intensities in the range of 400 nm ± 50 nm depth from the surface of the surface hard-coat layer was $6 \times 10^{-4}$. With a far-infrared reflectance of 87%, a surface abrasion resistance of 2 mm-wide or more scratches observed, and a photopic transmittance of 67%, the overall evaluations 1 and 2 resulted in C and D, respectively.

[Comparative Example 5]

A sample was obtained in the same manner as in Example 3 except the followings: In the step of forming the surface hard-coat layer, a methacrylic acid derivative (LIGHT ESTER P-2M manufactured by Kyoeisha Chemical Co., Ltd.) containing a phosphoric acid group was mixed into an acrylic hard-coating agent OPSTAR Z7535 manufactured by JSR Corporation so as to have 2% by mass in solid content, and the mixture was diluted to a solid concentration of 1.9% by mass, using methyl ethyl ketone as a dilution solvent, so that a coating liquid was obtained. The obtained coating liquid was applied using a bar coater (No.10). The results are shown in Tables 2 and 3.

The thickness of the surface hard-coat layer in Comparative Example 5 was 0.2 μm. With a far-infrared reflectance of 89%, a surface abrasion resistance of 2 mm-wide or more scratches observed, and a photopic transmittance of 64%, the overall evaluations 1 and 2 resulted in C and D, respectively.

[Table 1]

[Table 1]

| | | Structure | | | | | | | |
|---|---|---|---|---|---|---|---|---|---|
| | | | [B] Far-Infrared Reflecting Layer | | | [C] Surface Hard-Coat Layer | | | |
| | Product Name | [A] Substrate + [D] Inner Hard-Coat Layer | Material | Structure *1 | Surface Resistivity (Ω/□) | Main Component | Methacrylic Acid Derivative Containing a Polar Group/ Mass Content Ratio In Solid Content | Normalized Intensity Value [P/C] | Thickness |
| Example 1 | - | #100C0T0 | Ag Alloy | B1 | 1 | Z7535 | P-2M/2% | *2 | 0.8 μm |
| Example 2 | - | #100C0T0 | Ag Alloy | B1 | 7 | Z7535 | P-2M/2% | *2 | 0.8 μm |
| Example 3 | - | #100C0T0 | ITO/Ag Alloy | B2 | 9 | Z7535 | P-2M/2% | 1.3 | *2 |
| Example 4 | - | #100C0T0 | ITO/Ag Alloy | B2 | 9 | Z7535 | P-2M/5% | *2 | *2 |
| Example 5 | - | #100C0T0 | ITO/Ag Alloy | B2 | 9 | Z7535 | P-2M/10% | 6.2 | *2 |
| Example 6 | - | #100C0T0 | ITO/Ag Alloy | B2 | 9 | Z7535 | Surface Layer: None/0% Lower Layer: P-2M/2% | *2 | *2 |
| Example 7 | - | #100C0T0 | ITO/Ag Alloy | B2 | 9 | Z7535 | Surface Layer: None/0% Lower Layer: P-2M/10% | *2 | *2 |
| Example 8 | - | #100C0T0 | ITO/Ag Alloy | B2 | 9 | Z7535 | Surface Layer: None/0% Lower Layer: P-2M/20% | *2 | *2 |

*1 B1: Single Layer Structure, B2: Multilayer Structure, *2: No Actural Measurement Data

[Table 2]

[Table 2]

| | | Structure | | | | | | | |
|---|---|---|---|---|---|---|---|---|---|
| | | | [B] Far-Infrared Reflecting Layer | | | [C] Surface Hard-Coat Layer | | | |
| | Product Name | [A] Substrate + [D] Inner Hard-Coat Layer | Material | Structure *1 | Surface Resistivity (Ω/□) | Main Component | Methacrylic Acid Derivative Containing a Polar Group/ Mass Content Ratio In Solid Content | Normalized Intensity Value [P/C] | Thickness |
| Example 9 | - | #100C0T0 | $TiO_2$/Ti/Ag Alloy/$TiO_2$ | B2 | 6 | Z7535 | P-2M/2% | *2 | *2 |
| Example 10 | - | #100C0T0 | $TiO_2$/Ti/Ag Alloy/$TiO_2$ | B2 | 7 | Z7535 | -P-2M/2% | *2 | *2 |
| Example 11 | - | #100C0T0 | $Nb_2O_5$/Nb/Ag Alloy/$Nb_2O_5$ | B2 | 7 | Z7535 | P-2M/2% | *2 | *2 |
| Example 12 | - | #100C0T0 | $Nb_2O_5$/Nb/Ag Alloy/$Nb_2O_5$ | B2 | 13 | Z7535 | P-2M/2% | *2 | *2 |
| Comparative Example 1 | ZC05G | *2 | *2 | *2 | *2 | *2 | *2 | *2 | *2 |
| Comparative Example 2 | - | #100C0T0 | Ag Alloy | B1 | 7 | Z7535 | *2 | *2 | 0.8 μm |
| Comparative Example 3 | - | #100C0T0 | Ag Alloy | B1 | 7 | Z7535 | *2 | *2 | 3 μm |
| Comparative Example 4 | - | #100C0T0 | ITO/Ag Alloy | B2 | 9 | Z7535 | *2 | $6x10^{-4}$ | *2 |
| Comparative Example 5 | - | #100C0T0 | ITO/Ag Alloy | B2 | 9 | Z7535 | P-2M/2% | *2 | 0.2 μm |

*1 B1: Single Layer Structure, B2: Multilayer Structure, *2: No Actural Measurement Data

[Table 3]

[Table 3]

| | | Surface Abrasion Resistance | | Far-Infrared Reflectance | | Overall Evaluation 1 | Photopic Transmittance | | Overall Evaluation 2 |
|---|---|---|---|---|---|---|---|---|---|
| | Product Name | Scratch | Evaluation | (%) | Evaluation | | (%) | Evaluation | |
| Example 1 | - | 3 pcs/10 mm | A | 93 | A | A | 1 | C | C |
| Example 2 | - | 3 pcs/10 mm | A | 88 | A | A | 54 | B | B |
| Example 3 | - | 2 pcs/10 mm | A | 86 | A | A | 67 | A | A |
| Example 4 | - | 5 pcs/10 mm | A | 88 | A | A | 66 | A | A |
| Example 5 | - | 7 pcs/10 mm | B | 86 | A | B | 67 | A | B |
| Example 6 | - | 2 pcs/10 mm | A | 85 | A | A | 67 | A | A |
| Example 7 | - | 1 pc/10 mm | A | 85 | A | A | 68 | A | A |
| Example 8 | - | 4 pcs/10 mm | A | 85 | A | A | 68 | A | A |
| Example 9 | - | 4 pcs/10 mm | A | 86 | A | A | 52 | B | B |
| Example 10 | - | 3 pcs/10 mm | A | 85 | A | A | 72 | A | A |
| Example 11 | - | 3 pcs/10 mm | A | 86 | A | A | 53 | B | B |
| Example 12 | - | 5 pcs/10 mm | A | 80 | A | A | 70 | A | A |
| Comparative Example 1 | ZC05G | 11 pcs/10 mm or more | C | 81 | A | C | 66 | A | D |
| Comparative Example 2 | - | 2 mm-wide or more scratches | C | 87 | A | C | 53 | B | E |
| Comparative Example 3 | - | None | A | 54 | C | C | 54 | B | E |
| Comparative Example 4 | - | 2 mm-wide or more scratches | C | 87 | A | C | 67 | A | D |
| Comparative Example 5 | - | 2 mm-wide or more scratches | C | 89 | A | C | 64 | A | D |
| Comparative Example 6 | - | 2 mm-wide or more scratches | C | 11 | C | C | 73 | A | D |
| Comparative Example 7 | - | 2 mm-wide or more scratches | C | 9 | C | C | 74 | A | D |

INDUSTRIAL APPLICABILITY

The far infrared reflecting laminate of the present invention has a high far-infrared reflectance and a good surface abrasion resistance, so that it can be suitably used in applications for holding thermal environment by shielding thermal energy flown in and out from a window or the like. In particular, it can be suitably used in applications for suppressing outflow of the energy from a room during wintertime or the like.

DESCRIPTION OF REFERENCE SIGNS

1: Surface Hard-Coat Layer [C]
2: Far-Infrared Reflecting Layer [B]
3: Inner Hard-Coat Layer [D]
4: Substrate [A]

## Claims

**1.** A far infrared reflecting laminate wherein the following layers [A] to [C] are sequentially arranged in this order:

[A] a substrate;
[B] a far-infrared reflecting layer having the following structure [B1] or [B2],

[B1] a single layer structure of a metal containing 95 to 100% by mass of silver; or
[B2] a multilayer structure composed of a metal layer containing 95 to 100% by mass of silver and a layer which contains a metal oxide and/or a metal nitride and which has a refractive index of 1.5 to 3; and

[C] a surface hard-coat layer containing a crosslinking resin which has one or more polar groups selected from the group consisting of a phosphoric acid group, a sulfonic acid group, and an amide group and which has a thickness of 0.4 to 2.0 μm.

**2.** A far infrared reflecting laminate, wherein a substrate, a metal layer, and a surface hard-coat layer are arranged in this order, the metal layer containing 95 to 100% by mass of silver, the surface hard-coat layer having a thickness of 0.4 to 2.0 μm, and wherein the far infrared reflecting laminate has a far-infrared reflectance of 60% or more and a surface abrasion resistance of 10 scratches/10 mm or less.

**3.** The far infrared reflecting laminate according to claim 1 or 2, wherein the polar group contains a phosphoric acid group in the [C] layer.

**4.** The far infrared reflecting laminate according to any one of claims 1 to 3, wherein the following [D] layer is provided between the [A] layer and the [B] layer:

[D] an inner hard-coat layer composed of a crosslinking resin and having a thickness of 0.2 to 10.0 μm.

**5.** The far infrared reflecting laminate according to any one of claims 1 to 4, wherein the [C] layer has a multilayer structure or an inclined structure in which a composition continuously changes in the thickness direction, and
in the [C] layer, a normalized intensity value [P/C] (C1) obtained in a region [C1] in a range of 0 to 200 nm from an interface between the [C] layer and the [B] layer with a sector magnetic field type secondary ion mass spectroscope is 0.01 to 30.

**6.** The far infrared reflecting laminate according to claim 5, wherein in the [C] layer, a normalized intensity value [P/C] (C2) obtained in a region [C2] in a range of 0 to 200 nm from an opposite surface of the [B] layer with a sector magnetic field type secondary ion mass spectroscope is 10% or less of the normalized intensity value [P/C] (C1).

[FIG. 1]
1
2
3
4

**INTERNATIONAL SEARCH REPORT**

International application No.
PCT/JP2012/050372

A. CLASSIFICATION OF SUBJECT MATTER
*B32B15/08*(2006.01)i, *B32B7/02*(2006.01)i

According to International Patent Classification (IPC) or to both national classification and IPC

B. FIELDS SEARCHED

Minimum documentation searched (classification system followed by classification symbols)
B32B1/00-43/00, B05D1/00-7/26

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-138659 A (Toray Industries, Inc.), 24 June 2010 (24.06.2010), claim 1; paragraphs [0015] to [0019] (Family: none) | 1-6 |
| A | JP 2008-36864 A (Oike & Co., Ltd.), 21 February 2008 (21.02.2008), claims 1, 9; paragraph [0045] (Family: none) | 1-6 |
| A | JP 2000-117918 A (Teijin Ltd.), 25 April 2000 (25.04.2000), claim 1; paragraph [0054] (Family: none) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
05 April, 2012 (05.04.12)

Date of mailing of the international search report
17 April, 2012 (17.04.12)

Name and mailing address of the ISA/
Japanese Patent Office

Authorized officer

Facsimile No.

Telephone No.

Form PCT/ISA/210 (second sheet) (July 2009)

**INTERNATIONAL SEARCH REPORT**

International application No.
PCT/JP2012/050372

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-74079 A (Sanyo Chemical Industries, Ltd.), 09 April 2009 (09.04.2009), claim 1; paragraph [0004] (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP SHO58010228 B
- JP 2001310407 A